# EUROPEAN PATENT SPECIFICATION

(11) **EP 3 283 908 B1**
(45) Date of publication and mention of the grant of the patent: **25.12.2019**
(21) Application number: 16780581.1
(22) Date of filing: 13.04.2016
(51) Int. Cl.: G02B 5/20, G02B 5/28, G02B 1/14, G02B 1/11

(54) **DUAL COATING AND LIFT-OFF METHOD FOR DEPOSITING AND PROTECTING PATTERNED DIELECTRIC-METAL COATINGS**
DOPPELBESCHICHTUNG- UND ABHEBEVERFAHREN ZUM ABLAGERN UND SCHUTZ GEMUSTERTER DIELEKTRISCHER METALLBESCHICHTUNGEN
PROCÉDÉ DE REVÊTEMENT DOUBLE ET DE DÉCOLLEMENT POUR LA DÉPOSITION ET LA PROTECTION DE REVÊTEMENTS MÉTALLIQUES DIÉLECTRIQUES À MOTIFS

(30) Priority: 15.04.2015 US 201562147776 P
(43) Date of publication of application: 21.02.2018
(73) Proprietor: Ocean Optics, Inc., Largo FL 33777 (US)
(72) Inventor: POOL, Jeffrey, Largo, Florida 33777 (US)
(74) Representative: Spachmann, Holger
(86) International application number: PCT/US2016/027190
(87) International publication number: WO 2016/168232

(56) References cited:
- WO-A1-2015/195123
- US-A- 4 238 559
- US-A1- 2005 153 219
- US-A1- 2013 248 484
- US-A1- 2014 168 761
- US-A1- 2014 168 761
- US-B2- 7 648 808
- ABRISA TECHNOLOGIES: 'Physical Vapor Deposition - Sputtering vs. Electron Beam Evaporation' ABRISA TECHNOLOGIES, [Online] 25 February 2015, XP055322797 Retrieved from the Internet: <URL:hftp://web.archive.org/web/20150225180 648> [retrieved on 2016-06-09]

## Description

### FIELD OF THE INVENTION

This invention belongs to the field of thin film dielectric-metal coatings. More specifically it is a method of using a dual coating and lift-off method for depositing and protecting patterned dielectric and metal filter layers.

### BACKGROUND OF THE INVENTION

Several prior art methods of depositing and protecting dielectric -metal coatings are known such as the method described in U.S. Patent No. 7,648,808 B2 issued to Buchsbaum et al., which deals with a final blanket coat deposited on top of patterned features. In the Buchsbaum disclosed method features are patterned and deposited using a lift-off process followed by a novel final blanket coating step that completes the coating stack and results in passivation of the metal layer edges. The passivation of the metal layer edges prevents oxidation and corrosion of the metal. The final blanket layer can be a group of layers such as a final cavity mirror, anti-reflection layers, or a single layer of a material. These layers may use materials specifically selected for their corrosion resistant properties. This prior art technique is compatible with partially or fully populated patterned areas but utilizes a continuous blanket coating over the coated and uncoated patterned regions. It is not compatible with wafers with bond pads or similar uncoated area requirements.

US 2014/0168761 A1 discloses a method for forming a patterned optical filter comprising dielectric and metal layers. A dual-layer photoresist is applied to a substrate and patterned to form an undercut. Then a multilayer stack corresponding to the optical filter layers is deposited by evaporation or sputtering. A portion of the multilayer stack on the patterned photoresist layer is lifted off and an additional dielectric coating is deposited to protect the optical filter from the environment.

Finally US 2013/0248484 A1 refers to a method for fabricating a patterned dichroic filter with several steps of providing an inorganic layer on a substrate, forming a dichroic film on the patterned material layer and removing the patterned material layer and simultaneously removing a portion of the dichroic film disposed on the patterned material layer.

By using the 2-layer process disclosed in this application the prior art's limitations described above can now be overcome.

### BRIEF SUMMARY OF THE INVENTION

The invention of this disclosure is a method according to claim 1.

### BRIEF DESCRIPTION OF THE DRAWINGS

For a fuller understanding of the nature and objects of the invention, reference should be made to the following detailed description, taken in connection with the accompanying drawings, in which:

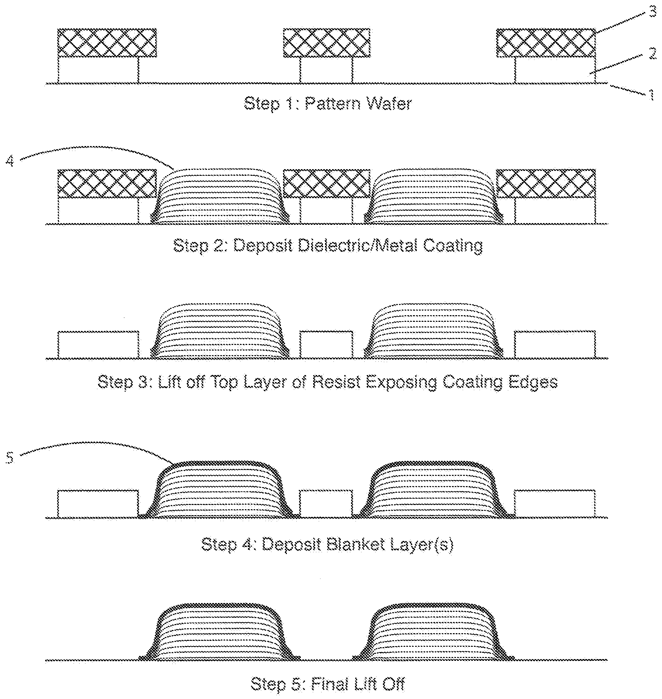

FIG. 1 is a diagram showing the steps of the preferred embodiment of this disclosure.

### DESCRIPTION OF THE PREFFERED EMBODIMENT

The preferred embodiment of this method starts with a 2-layer lift-off lithography process on a wafer (1) consisting of depositing bottom layer lift-off resist 2 (LOR) and top layer resist 3 (1822 resist, or other materials such as etch compatible resists that can be determined by those skilled in the art after reading this disclosure), which is then exposed and developed to create a 1-4 micrometre undercut in the bottom layer lift-off resist 2 (LOR). Next, the wafer 1 is coated with a 0.25 - 5 micrometre metal/dielectric thin film filter 4 that ends with an incomplete final coating layer. Next any metal/dielectric thin film filter 4 excess coating and top layer resist (1822 resist) 3 layer are selectively lifted off using acetone or equivalent, exposing the metal edges of the deposited metal/dielectric thin film filter (4) and leaving the bottom layer lift-off resist 2 (LOR) pattern intact on the wafer 1.

This leaves the patterned metal/dielectric thin film filter coating 4 with a 1-4 micrometre larger patterned perimeter, based on the size of the original bottom layer lift-off resist 2 (LOR) undercut. Then a final blanket layer 5 is deposited to complete the deposited thin film filter coating 4 and passivate the metal layer edges. The final blanket layer deposition 5 can also consist of a multiple layer stack for some applications. Finally lift off the bottom layer lift-off resist 2 (LOR) and excess blanket layer deposition 5 leaving the patterned features on the wafer 1.

The steps of this 2-layer process are shown in FIG. 1 as follows:
First pattern a wafer 1 with a 2-layer process of bottom layer lift-off resist 2 (LOR) and top layer resist 3 (1822 resist), which is then exposed and developed to create a 1-4 micrometre undercut in the bottom layer lift-off resist 2 (LOR).

Next deposit the dielectric and metal filter layers 4 onto the patterned wafer 1 with an evaporation or sputtering process.

Then lift off the top layer resist 3 (1822 resist) and any excess dielectric and metal filter material 4 leaving the bottom layer lift-off resist 2 (LOR) intact on the wafer 1 and exposing the metal layer edges of the dielectric and metal filter layers 4.

Then deposit the final blanket coating(s) 5 in the enlarged bottom layer lift-off resist 2 (LOR) pattern to protect metal coating edges of the dielectric and metal filter layers 4 and complete the coating stack 4 and 5.

Then lift off the bottom layer lift-off resist 2 (LOR) and any excess final blanket coating(s) 5 leaving the patterned features.

## Claims

1. A dual coating and lift-off method for depositing and protecting patterned dielectric and metal filter layers using a two-layer lithography process wherein the two-layer lithography process comprises:
first patterning a wafer (1) having a bottom layer lift-off resist (2) and a top layer resist (3) by exposing and developing said bottom layer lift-off resist (2) and said top layer resist (3) to form said patterned wafer (1) and to create an undercut in said bottom layer lift-off resist (2) for providing an enlarged bottom layer lift-off resist (2) pattern;
next depositing dielectric and metal filter layers (4) onto said patterned wafer (1) using an evaporation or sputtering process;
then lifting off said top layer resist (3) and any excess deposited dielectric and metal filter material leaving said enlarged bottom layer lift-off resist (2) pattern intact on said wafer (1) and exposing any metal layer edges of said deposited dielectric and metal filter layers (4) in said enlarged bottom layer lift-off resist (2) pattern;
then depositing one or more final blanket coatings (5) within said enlarged bottom layer lift-off resist (2) pattern to protect said metal layer (4) edges and complete a coating stack (4, 5); and,
then lifting off said enlarged bottom layer lift-off resist (2) pattern and any excess final blanket coating (5) leaving patterned features on said wafer (1).

## Patentansprüche

1. Zweifach-Beschichtungs- und Lift-off-Verfahren zum Aufbringen und Schützen von strukturierten Dielektrikum-/Metallbeschichtungen mittels eines Zwei-Schichten-Lithographie-Prozesses, wobei der Zwei-Schichten-Lithographie-Prozess die folgenden Schritte umfasst:
zunächst Aufbringen einer Struktur auf einen Wafer (1) mit einer unteren Lift-off-Fotolackschicht (2) und einer oberen Fotolackschicht (3) durch Belichten und Entwickeln der unteren Lift-off-Fotolackschicht (2) und der oberen Fotolackschicht (3), um den strukturierten Wafer (1) zu bilden und eine Unterschneidung in der unteren Lift-off-Fotolackschicht (2) zu erzeugen, um eine vergrößerte Struktur der unteren Lift-off-Fotolackschicht (2) zu erhalten;
als nächstes Aufbringen von Dielektrikum- und Metall-Filterschichten (4) auf den mit der Struktur versehenen Wafer (1) mittels eines Verdampfungs- oder Sputter-Prozesses;
dann Entfernen der oberen Fotolackschicht (3) und aufgebrachten überschüssigen Materials der Dielektrikum- und Metall-Filterschicht, so dass die vergrößerte Struktur der unteren Lift-off-Fotolackschicht (2) intakt auf dem Wafer (1) zurückbleibt und alle Metallschicht-Kanten der aufgebrachten Dielektrikum- und Metall-Filterschichten (4) in der vergrößerten Struktur der unteren Lift-off-Fotolackschicht (2) frei liegen;
danach Aufbringen einer oder mehrerer abschließender Deckbeschichtungen (5) innerhalb der vergrößerten Struktur der unteren Lift-off-Fotolackschicht (2), um die Metallschicht-Kanten (4) zu schützen und einen Beschichtungs-Stapel (4) und (5) abzuschließen; und
danach Entfernen der vergrößerten Struktur der unteren Lift-off-Fotolackschicht (2) und überschüssiger abschließender Deckbeschichtung (5), so dass die strukturierten Elemente auf dem Wafer (1) zurückbleiben.

## Revendications

1. Un procédé de revêtement double et de lift-off pour déposer et protéger des couches à motifs en diélectrique-métal à l'aide d'un procédé de lithographie bicouche sachant que le procédé de lithographie bicouche comprend :
tout d'abord, l'impression des motifs sur un wafer (1) ayant une couche inférieure de résine photosensible lift-off (2) et une couche supérieure de résine photosensible (3) en exposant et développant ladite couche inférieure de résine photosensible lift-off (2) et ladite couche supérieure de résine photosensible (3) pour former ledit wafer à motifs (1) et créer une dépouille négative dans ladite couche inférieure de résine photosensible lift-off (2) afin d'obtenir un motif élargi de la couche inférieure de résine photosensible lift-off (2) ;
puis, le dépôt de couches filtrantes diélectrique-métal (4) sur ledit wafer à motifs (1) à l'aide d'un procédé d'évaporation ou de pulvérisation cathodique ;
ensuite, le retrait (lift-off) de ladite couche supérieure de résine photosensible (3) et de tout excédent du matériau filtrant diélectrique-métal en laissant intact ledit motif élargi de la couche inférieure de résine photosensible lift-off (2) sur ledit wafer (1) et en exposant les bords de couche métallique desdites couches filtrantes diélectrique-métal déposées (4) dans ledit motif élargi de la couche inférieure de résine photosensible lift-off (2) ;
ensuite, le dépôt d'un ou de plusieurs revêtements finaux de couverture (5) à l'intérieur dudit motif élargi de la couche inférieure de résine photosensible lift-off (2) pour protéger lesdits bords de couche métallique (4) et terminer un empilement de revêtements (4, 5) ; et,
enfin, le retrait (lift-off) dudit motif élargi de la couche inférieure de résine photosensible lift-off (2) et de tout excédent du revêtement final de couverture (5) en laissant les caractéristiques du motif sur ledit wafer (1).
